# EUROPEAN PATENT APPLICATION

(11) **EP 3 012 786 A1**
(43) Date of publication of application: **27.04.2016**
(21) Application number: 15190465.3
(22) Date of filing: 19.10.2015
(51) Int. Cl.: G06Q 10/06, G06Q 50/06

(54) **POWER DISTRIBUTION NETWORK FAULT MANAGEMENT**

(30) Priority: 20.10.2014 NL 1041003
(71) Applicant: Madamange, 1161 Luxembourg (LU)
(72) Inventor: Van Velsen, Francis Igor Serge Alain Laurent, 1161 Luxembourg (LU); Slikker, Ilco, 1056 DP Amsterdam (NL)
(74) Representative: Hoffmann Eitle

(57) **Abstract**

Use of a computer and an executable computer program on such a computer for the handling of an impairment of a cables and/or conduits infrastructure in an area, the impairment encompassing an observed defect of the infrastructure and/or an at least partially insufficiently functioning or fully malfunctioning infrastructure of cables and/or conduits in the area, the program being designed to have the computer perform a multiple of steps.

## Description

The invention relates to the use of a computer and an executable computer program on such a computer for the handling of an impairment of a cables and/or conduits infrastructure in an area. The invention also relates to such an executable computer program.

### Background

An impairment within the context hereof is defined as an observed defect either causing a function decrease of the particular utility infrastructure or not, as well as a partially or entirely decrease in functioning or a failure in functioning of the cables and/or conduits infrastructure.

Impairments are an unpleasant interruption of the functioning of many systems, particularly when the impairment occurs within the electricity grid, or in a data transport system using a cables and/or conduits network. However, equally an interruption of a water supply system can be particularly unpleasant.

In some parts of the world, sudden and nature caused changes in the stability of the landscape or the bottom of the sea can lead to impairments in infrastructural networks. The extent and the nature of such failure of cables and/or conduits networks due to a tsunami or earthquake is difficult to cope with. In such situations, typically a complete renewal is the only possibility to enable restored provision of the infrastructure. In some areas in the world, frequently deteriorated weather conditions are by far the most important cause of impairments. For those areas it is not unusual to use a management system to remedy impairments based on historical knowledge about disruptions at certain weather conditions.

Such a system is known from and for example described in WO 2005/0455547 A2. This document discloses a method and a system for managing an expected and/or already occurring number of impairments, each of which will take or is already taking place due to strongly deteriorated weather conditions in the electricity network. Within the system, knowledge of the components of the network are linked to knowledge of the weather predictions, in order to predict possible future impairments, based on modeling and particularly on predictions derived thereof.

US 5,568,399 equally discloses a method and a system for determining possible impairments that could eventually follow from an impairment occurring in the network. This tool for the management of impairments aims at monitoring the entire network and at managing an expected multiple of impairments.

Equally on an incidental impairment level, however, there are several options for responding, each response having consequences for the functioning of the network on the short term and on the long term. In the following, the focus is on dealing with an individual impairment.

Whenever an impairment of a cables and/or conduits infrastructure in a service area is reported to the utility infrastructure administrator (also referred to as a grid operator or grid manager), two conflicting interests are to be dealt with when it comes to handling that impairment. On the one hand it is of eminent importance to fix the cause of the impairment as quick as feasible for the purpose of (reestablishing or maintaining) the proper functioning of the infrastructure and for the purpose of preserving the price (regulated by legislation) that is to be paid for making use of the utility grid and/or the use of the utility grid (the downward correction of that price will be referred to hereinafter as the cost per disruption minute for the grid manager). On the other hand there is an equally eminent interest to properly record impairment data on the basis of which the cause and the possible person responsible for causing the impairment can be determined, for example enabling to to claim (from that person responsible) the repair costs and possible other damages.

For a proper understanding of the invention, it is highlighted that damage can only be properly claimed from any person in case one can prove that the impairment of that particular part of the infrastructure has been caused by that person. A causal connection between the cause of the impairment and the damages incurred is to be proven.

As the number of disruption minutes has a downward effect (through the regulatory legislation system) on the price to be paid for making use of the utility grid and/or the utility use, the priority for a grid operator is with the re-establishing or maintaining the utility delivery, while the properly recording of impairment data (on the basis of which the cause and the possible person responsible for causing the impairment can be determined) is at times (somewhat) disregarded. This then leads to a situation that because of insufficient recording of data, an action for damages is impossible and the case is to be converted to an "irrecoverable" impairment case. Such a conversion is necessary whenever an action for damages against the person or entity that caused the infrastructure damage is impaired by said insufficient availability of usable data. As a possible consequence, any person or entity causing the infrastructure impairment runs a relatively low risk of being held responsible and/or liable, which may lead to a lack of due care amongst infra construction workers, and in turn may result in an increase of infrastructural impairments. This will then increase the chance of infrastructure impairments, which will then lead to a decrease in the price to be paid for making use of the utility grid and/or the utility use.

If the choice were to be made to indeed thoroughly record the data on the basis of which a plausible party liable for the infrastructure impairment can be determined, valuable minutes for repair of the infrastructural impairment may be lost, which may in turn result in an action against the liable party, however probably at the cost of the price that is to be paid for making use of the utility grid and/or the utility use.

It is a purpose of the invention to offer a solution for not being able to simultaneously represent the both abovementioned interests while resolving infrastructure impairment.

Said purpose of the invention can be achieved by employing a computer and an executable computer program running on that computer for handling any impairment with respect to a cable and/or conduits infrastructure in an area, said impairment being an observed defect either causing a function decrease of the particular utility infrastructure or not, and/or or a partially or entirely decrease in functioning or a failure in functioning of the cables and/or conduits infrastructure. The program is designed to have the computer perform the following steps:
- determining the commencement time of the impairment, using the data from a NESTOR-impairment registration system or any equivalent grid impairment management system;
- determining the position of the relevant area;
- determining one or more objects causing the impairment, on the basis of the determined position and a Geo Information System (GIS) related database of one or more grid operators;
- determining one or more causes of the impairment, on the basis of the determined position and a database that in the relevant area and within a predetermined time frame prior to the impairment holds notifications from the Information Site regarding Cables and Conduits (KLIC);
- determining the most probable cause of the impairment, based on the multiple cause probabilities, preferably using the location of the impairment and the commencement time thereof, and the time and location of the notifications registered with the relevant Information Site regarding Cables and Conduits.

A Geo Information System (GIS) related database of one or more relevant grid operators contains detailed information with drawings of the infrastructure both subterranean and above surface. The drawings depict the geographical position of the cables and conduits (and other infrastructural works) of the relevant grid operator. A grid operator with an infrastructure for gas, electricity and fibre optics will therefore avail of GIS-data with respect to its gas conduits, electricity cables and fibre optic cables. The database also contains information with regard to the number of users of a relevant part of the infrastructure.

A database that in the relevant area and within a predetermined time frame prior to the impairment holds notifications from the Information Site regarding Cables and Conduits (KLIC), is generally up-to-date as anyone planning to execute works that may influence the infrastructure, needs to give notice of such (excavation) works. Such a notification generally results in the provision to the contractor of the detailed drawings indicating the location of cables and conduits.

To determine "realtime", means - e.g. in context of determining the position "online", and preferably instantaneously and automatically - the ability to read data from the Geo Information System (GIS) related database of one or more relevant grid operators and for instance the "online" consulting, preferably instantaneously and automatically, of a database that in the relevant area and within a predetermined time frame prior to the impairment holds notifications from the Information Site regarding Cables and Conduits(KLIC) or equivalent notifications.

The determination of one or more probable causes can, for example, include a list of possible objects that each could have led to the impairment in case of malfunctioning, based on the object's location in the area. Based on the notifications from the Information Site regarding Cables and Conduits (KLIC) in the relevant area and within a predetermined time frame prior to the impairment, a further selection can be made. Initially for example, non-functioning cables and loosened connections can be flagged as probable causes. Such flagging of a probable cause relates to determining that an object is not functioning properly. The determination of a probable cause hence covers the selection of an object not functioning properly, and thereby at least contributing to the realisation of the impairment. A malfunctioning cable can be a probable cause of the impairment; whether this is due to a crack in the cable or due to a short circuit is for the time being of less concern while determining the probable cause. As a second step, the notifications with the Information Site regarding Cables and Conduits or equivalent notifications may confirm a probable cause as a probable cause, especially whenever the time prior to the impairment of any notification with the Information Site regarding Cables and Conduits and the area it applies to respectively, conform to the impairment. The announced excavation work in the notification from the Information Site regarding Cables and Conduits for a location where a cable can be found, can lead to a crack in or a short circuit of the cable, whereby the cable can be flagged as the probable cause of the impairment. Subsequently, the determination of the most probable cause is done on the basis of the commencement time and the location of the impairment, and preferably also on the notifications with the Information Site regarding Cables and Conduits (KLIC). This last step is presented automatically. The execution of this last step can be done on either a human decision or program execution basis.

The preprogrammed and preferably automatic execution of the steps and the determination of the most probable cause of the impairment, based on the multiple cause probabilities, will benefit both the speedy resolution of the infrastructure impairment and the preservation of action against the liable party. So when it is for example determined that the cable is likely non-functioning due to a crack, and that is the most probable cause of the impairment, a contractor of excavation works may be found to be the most probable originator of the impairment. The information that is relevant for a quick resolution of the impairment and the information that is relevant to be able to hold the possible originator of the impairment responsible, will partly correspond, which may result in both a quick resolution of an impairment and a quick settlement of a recoverable loss.

In a further embodiment, the determination of the position of the relevant area is performed by importing of locations, preferably in the area by means of a GPS system. The data can be entered manually, similar to the adjusting of an address at a car's navigation system based on GPS, but it is also possible to enter the data via the GPS system, where the user only has to verify that his or her position is the location of relevance. The determination of the position in the relevant area by means of a GPS system allows the program for example to be run on a mobile phone enabling an employee, directly working for or commissioned by a grid operator, to visit the impairment area and record the actual situation. He or she can, for example, visit the area to make photographs of the contractor that has excavation works in progress at the impairment area.

In another embodiment according to the invention, the program is set up to have the computer equally perform the following step:
- determining the most probable originator (of the infra-structure impairment) on the basis of the most probable cause.

This further step provides the opportunity to directly, and preferably also automatically, inform the originator of the infrastructure impairment that the resolution of the infrastructure impairment takes place directly, also in the originator's interest. As will be further described below in more detail, the price that is to be paid for making use of the utility grid and/or the utility use, is often dependant of the number of disruption minutes per time unit, sometimes in correlation with the frequency of disruptions. Should a probable originator (of the infrastructure impairment), after being informed of the infrastructure impairment, hinder a speedy processing, and more importantly, a speedy resolution of the infrastructure impairment, then also that further delay can cause price erosion for the grid operator, resulting in a price erosion damage that can be claimed from the originator (of the infrastructure impairment).

In a further embodiment the program is also set up to have the computer additionally perform the following step:
- determining the number of man-hours worked and/or the materials required with respect to the restoration of the infrastructure impairment.

Also this step provides for enhancing the speed of both resolving the infrastructure impairment and the action against the originator of the infrastructure impairment, securing a cost effective grid management. The determination of the number of man-hours worked and/or materials required can be done afterwards, but it can also be done in advance, which would then set a standard for the repairing mechanic in the repair time of the infrastructure impairment.

In yet another embodiment the program is also set up to have the computer equally perform the following step:
- in determining the number of man-hours worked, equally determine the associated hourly fee and/or in determining the materials required with respect to the repair of the infrastructure impairment, equally determine the price data for those materials (whether or not via a centrally managed database).

In this manner, the repair costs (as part of the damage incurred) are effectively managed, fully in line with the purpose of handling the resolution of the infrastructure impairment and settling the damage as much in parallel as feasible.

In a further embodiment the program is also capable to have the computer perform the following step:
- collecting image data supporting a damage claim.

This embodiment is particularly of use when resolving an impairment is accompanied by a visit to the area where the impairment of the infrastructure has been located.

Furthermore the program can be designed to be capable of performing the following step:
- registration of the end time of the impairment for the recording of the impairment duration.

This is an important factor for the determination of the price that is to be paid for making use of the utility grid and/or the utility use of the infrastructure. With a large amount of disruption minutes and/or a high frequency of impairments, the price that is to be paid will be under pressure and will be decreased according to a regulated formula. However, the vice-versa scenario is also possible: in case of a decrease in disruption minutes and/or a very low frequency of impairments, the infrastructure can be considered as being of high quality, justifying an increase of the price (both scenarios on the basis of the same formula from regulating authorities).

Preferably the program is also designed to be able to perform the next step:
- real-time reporting of the time of restoration of the impairment, so that data can be updated real-time in the NESTOR-impairment registration system or any equivalent grid impairment management system.

In another embodiment the program is preferably designed to perform the next step:
- real-time reporting of the adjustments in the infrastructure accomplished by the repair, for the purpose of updating the Geo Information System (GIS) related database of the concerning grid operator of the infrastructure.

This step contributes to updating the database as soon as possible, which will prevent that with possible new notifications of excavation works/infrastructural activities (via the Information Site regarding Cables and Conduits or otherwise or equivalent notification), new impairments occur in the same area, because the updated data have not yet been recorded in the GIS-database.

In a preferable embodiment, the program is also designed to perform the following step:
- to generate a damage form for the accurate recording of data related to the impairment.

With this step, the settlement of any damage claim can be performed effectively. Any threshold to register an impairment as an actionable damage with a chance of recovery, becomes very low with this feature.

In a further embodiment the program is designed to perform the following step:
- to calculate - based on the available data, among which data about the commencement time of the impairment, the end time of the impairment, the Geo Information System (GIS) related database in which the amount of users that are connected to the damaged infrastructure, the total amount of disruption minutes and the percentage of actionable damages on the total amount of impairments and fixed variables as introduced in the system - the costs per disruption minute for the grid operator. This allows for the possible recovery of (also) these costs from the originator of the impairment.

In a preferred embodiment, the program is also designed to perform the following step:
- to generate an objects database comprising of a multiple of objects together with a value for each object, wherein each value corresponds to the number of times that the relevant object in a predefined timeframe was indicated as the most probable cause.

With this step a database can be generated that could be used for determining one of more probable causes and/or for determining the most probable cause. Equally, in doing so one can determine the costs in advance of objects that are regularly the cause of an impairment, resulting in the availability of a fixed low price for such an object. With this feature the chance for a fluent handling of the impairment will increase.

In a further embodiment, the program is also designed to perform the following step:
- to generate a repair time database comprising of a multiple of objects, with for each object a total repair time needed for the specific object.

With this step, the total impairment duration time can be determined relatively quickly, and can for instance be determined in advance. It provides the opportunity to offer the originator an accelerated settlement based on an assumed/fixed repair time.

In yet another embodiment, the program is also designed to perform the following step:
- to flag, during the repair of an object, to what extent the current repair time is in line with the repair time that is recorded in the repair time database for that object.

This feature allows for the management of resolving impairment, with a multiple of opportunities to encourage employees to work faster or to discourage them to work slower.

In one embodiment, the program is also designed to perform the following step:
- to flag, based on the object database, that a critical value is surpassed, indicating that one or more objects need to be replaced in order to avoid that one or more of the objects will again, with an identical probability, be determined as the cause of an impairment.

This allows for the network preservation and to prevent an(other) impairment, likely non-recoverable, for instance because of old age.

With this feature the amount of disruption minutes can be kept at a low(er) level.

In a preferred embodiment, the program is also designed to perform the following step:
- to generate a database comprising of both a number of impairment causes and an associated value for each of the impairment causes, the associated value corresponding to the number of times the relevant cause within in a predetermined timeframe was actually determined the most probable cause.

Generally, one can distinguish within the multitude of causes, in "internal cause", for example the age of an object, and "external cause", either by conditions e.g. a natural disaster (a cause that results in an impairment, but probably not in a recoverable damage) or by third parties, typically excavation works (a cause that results in an impairment and probably also in a recoverable damage). One may use such a database of distinguished impairment causes to determine the most probable cause of an individual impairment.

The database of distinguished impairment causes can be generated through real-time entry of data from a computer and an executable computer program on such a computer for the handling of impairments, which has as a step the determination of a most probable cause.

In a preferred embodiment, the program is also designed to perform the following step:
- to generate a database of impairment originators comprising of an amount of possible originators of impairments, as well as a value corresponding to the number of times that, within a predefined timeframe, a possible originator has been determined as the most probable originator.

As a rule, this will apply to recoverable impairments only. This embodiment can be of use for selecting a contractor executing the excavation works. Furthermore, awareness can well be developed amongst contractors that such a database, in which its relative reliability is being recorded, is being generated. This may result in contractors working more reliably.

In a further preferred embodiment, the impairment originators database is being generated by means of the real-time entry of data from a computer and an executable computer program on such a computer for the handling of impairments in the infrastructure, in which the most probable originator is being determined for each impairment.

In another preferred embodiment, the program is also designed to perform the following step:
- to display the relevant objects within the infrastructure, using the determined position and the Geo Information System (GIS) related database of one or more grid operators of the infrastructure.

A detailed view of the grids of different utilities (water supply, sewer system, electricity, data transport, gas, etc.) being available in one record, will benefit the handling of an impairment with due observance of those data.

In yet another embodiment, the program is designed to allocate a qualification to the objects that belong to the infrastructure, corresponding to the nature of the medium that flows through the object concerned within that infrastructure. In this manner, a gas conduit and a water conduit will be displayed perceptibly different.

In a further embodiment, the program is designed to allocate a quantification to the objects that belong to the infrastructure corresponding to the intensity of the medium that flows through the object concerned. A high pressure gas conduit and a low pressure gas conduit will be displayed perceptibly different.

In a further embodiment, the program is designed to visualise the infrastructure of cables and/or conduits in an area.

In another embodiment, the program is designed to indicate, per position from which the infrastructure can be invasively entered, the relative risk of damaging at least part of the infrastructure. With this feature, the program can be used for many purposes, equally to prevent any further impairment.

In one embodiment, the program is designed to perform the following steps:
- to authorise the user of the computer program to confirm or change of the most probable cause of the impairment as determined by the computer program;
- to generate a notification to the user, as soon as a change or confirmation has been entered, to confirm or change the entered change or confirmation.

This feature prevents the handling of impairment on the basis of erroneous conditions.

In a further embodiment, the repair time database will be generated by the real-time entry of data from a computer and an executable computer program (on such a computer) for handling impairments.

In another embodiment, the program is designed to select a mechanic, based on the real-time database that manages the position of mechanics, for the relocation to a position in the relevant area in which impairment has been reported. This enables the effective handling of impairments.

In a further embodiment, the selection of a mechanic is made on the basis of a comparison of the time calculations, indicating for a multiple of mechanics, the amount of time the relocation will take. The selection process can be further improved by comparing time calculations indicating how much time an already commenced repair will probably take.

These optimisations all contribute to reaching the goal of maintaining the disruption time at a low as possible level, without making it more attractive to record any impairment as a unrecoverable loss.

The invention and particular embodiments of the invention will now be described in more detail by means of an example.

With the entry of an impairment notification, it will be recorded in the so-called NESTOR impairment registration system or any equivalent grid impairment management system for an infrastructure of cables and/or conduits. The impairment could comprise of an observed defect, for example an underground cable with its insulating casing having been scratched off as a result of excavation works. The impairment may not necessarily noticeably influence the functioning of relevant infrastructure yet. The impairment may, however, result in an insufficiently or entirely mal-functioning of infrastructure of cables and/or conduits in the relevant area. An assignment for the resolution of the impairment is given to an employee of for instance a grid operator or an organisation that is in charge of the resolution of the impairment.

The employee uses a computer and an executable computer program on such a computer for handling impairments within an infrastructure of cables and/or conduits in an area. The program is designed to have the computer determine the start time of the impairment by retrieving data from the NESTOR impairment registration system or any equivalent grid impairment management system for the infrastructure. Based on said retrieval, a clock routine counting the disruption minutes, can record the duration of the impairment, by taking the retrieved time as a starting point, and further recording real-time from that point on. The program is also designed to determine the position in the relevant area by manual entry or GPS localisation.

On the basis of the position as determined, the program establishes a connection, preferably online and automatically, with the Geo Information System (GIS) related database of one or more grid operators of the infrastructure. A Geo Information System (GIS) related database of one or more relevant grid operators contains detailed information with drawings of the infrastructure both subterranean and above surface. The drawings depict the geographical position of the cables and conduits (and other infrastructural works) of the relevant grid operator. A grid operator with an infrastructure for gas, electricity and fibre optics will therefore avail of GIS-data with respect to its gas conduits, electricity cables and fibre optic cables. Based on the requested and retreived GIS-data for the relevant area, the employee can determine which object or which objects (probably of with certainty) are the cause of the impairment.

The employee can for example be given the option to make an independent decision and to select the object or objects that according to his or her assessment have caused the impairment, e.g. on the basis of the impairment notification. It is, however, also possible to have a routine within the program determine the objects on the basis of given answers to particular questions. A skilled person could develop a tailor-made dynamic questionnaire to this end.

Next, the question is to be addressed which cause or causes have probably led to the impairment. For this purpose, the program is designed to have the computer connect with a database that in the relevant area and within a predetermined time frame prior to the impairment holds notifications from the Information Site regarding Cables and Conduits (KLIC) or equivalent notifications. These are notifications from entities planning to execute (construction) works that may influence the infrastructure. Such a notification generally results in the provision to the contractor of GIS-data, enabling the contractor executing the construction works to get acquainted with the local (subterranean) situation, and try to reduce the chances of damaging the infrastructure when executing the construction works. The most recent notifications with the Information Site regarding Cables and Conduits in the database, prior to the start of an impairment, provide insight in the works that may be a possible cause of the impairment. Hence, it is possible to show the one or more probable causes of the impairment, on the basis of the position, the relevant points in time and the relevant notifications with the Information Site regarding Cables and Conduits (or equivalent notifications).

Based on one or more probable causes, the most probable cause of the impairment can be selected, for instance by means of a selection executed by the employee, or by means of a subroutine that is designed to this end and implemented in the program. The subroutine may comprise of a calculation of probability, based on experiential data.

The program is optionally designed to determine the most probable originator on the basis of the most probable cause. This can be done either immediately, or at a later stage. Optionally, the originator is informed (automatically) of the impairment as caused, of the settlement thereof and of the connection with the kind of activities that have been determined as the cause of impairment.

For the purpose of the repair of the impairment or its resolution in any other way, the program optionally determines the man-hours spent and the required materials. This can be done in advance, for instance based on the database containing experiential data, by indicating - based on GIS-data or other data as assessed, location, depth, etc. - how many man-hours should be spent and what materials (length, type, etc.) should be required. The data can, however, also be entered manually afterwards on the basis of an actual assessment.

Together with the assessment of man-hours spent, the associated hourly rate can also be determined. Together with the assessment of required materials, the associated price information can be retrieved, for example real-time (online) and preferably automatically, to establish an accurate and for example most favourable mode of operation for the purpose of resolving an impairment.

The program can also be designed to record one or more visual details to support a possible damage claim, for example with a digital camera that is integrated in or connected to the computer.

Next, the end time of the impairment can be recorded, for the purpose of determining the duration of the impairment. To this end, the program can be designed in different ways. Optionally, the end time of the impairment can be defined as the commencement time of the regularly functioning of the infrastructure. One may also define the end time as (of) the moment that both the infrastructure is functioning properly and the observed damage has been repaired. Furthermore, one may opt for a definition of the end time as the moment of recording (be it fully supported or not) whether or not the impairment has been caused by a third party or for example as a consequence of a sudden surcharge of the infrastructure (for example caused by flood, too intensive use of the infrastructure, etc.).

Preferably, the program will record real-time the end time of the impairment for the purpose of real-time updating the data in the NESTOR-impairment registration system or any equivalent grid impairment management system for the infrastructure.

The program may also be designed to register the total duration of the impairment, calculated on the basis of the retrieved commencement time of the impairment and to send the data to those (predetermined) databases that, for the proper record of information, are dependent on retrieval of those data.

Within the same framework is the real-time reporting of any adjustment (of the infrastructure) to the Geo Information System (GIS) related database of the relevant grid operator. If the occasion arises, a deviating location can also be registered real-time.

A standard subroutine within the program may also be the generation of a damage report for the proper recording (on the basis of all available data) of data relevant for a damage claim.

In an advanced variant the total amount of disruption minutes and the percentage of damages in proportion to the total number of impairments is being calculated on the basis of the available data, amongst which the commencement time of the impairment, the end time of the impairment, the Geo Information System (GIS) related database including the number of users connected to impaired infrastructure, and other fixed variables as implemented in the system. This enables the calculation of the costs per disruption minute for the grid operator.

The program can be designed to include these costs per disruption minute as an item of loss in the damage claim to the originator of the impairment.

Further analyses and calculations are possible, like for example the list of the total amount of damage cases in comparison to the total amount of impairments. With these calculations the success of the invention can be quantified.

One of the calculations that can be executed relates to the costs for a grid operator for maintaining the facilities to resolve impairments. After all, the grid operator has a number of external mechanics (or multiple teams even) on standby, mostly on a 24/7-basis, just in case of a required simultaneous recovery of impairments of a different category. Besides, the grid operator often has one or more teams of its own employees stand-by on a 24/7-basis. The annual costs hereof are significant. If the total annual costs for these facilities are known by the grid operator, use of the program enables to calculate the costs of these impairment facilities per impairment, on the basis of the duration of that particular impairment.

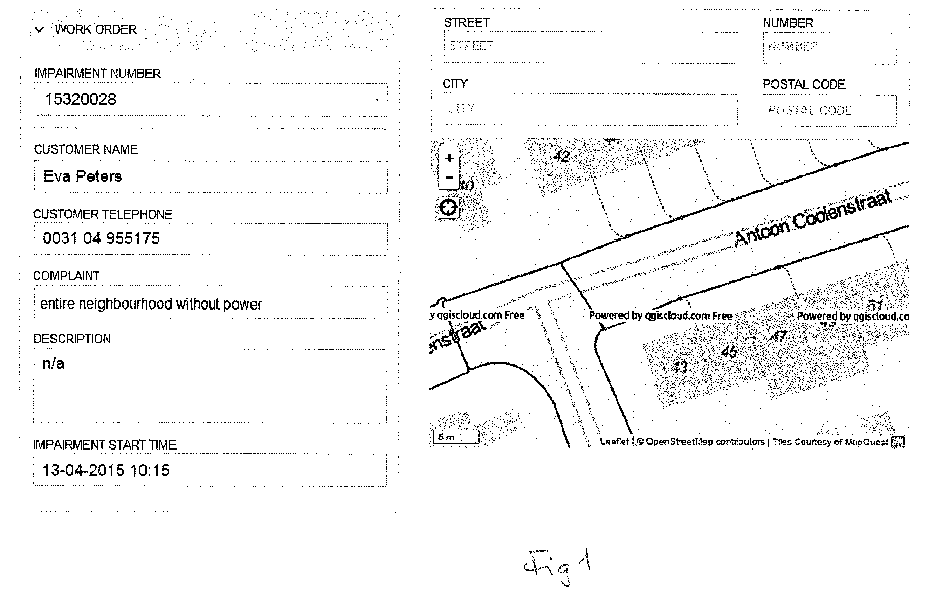

A more detailed example of the invention is now being described with reference to the drawings, figures 1 to 7 including, each figure showing a screenshot of an image that may be generated on screen while using an embodiment of the invention.

It will become clear that embodiments are intended for handling impairments in such a way that two separate tasks need to be executed simultaneously, that is, on the one hand resolving the impairment as quickly as feasible, while on the other hand recording the details of the impairment and loss and claiming damages from the originator. The program enables the user to execute these two tasks quickly and effectively. Figures 1 to 7 including show which steps are being executed within an embodiment for a computer program for handling impairments.

Figure 1 is an exemplary image generated for the entry per telephone of the first notification of impairment, the notification being a complaint by phone and the person calling in the complaint leaving his or her name and phone number. An impairment number is then being generated, and equally the time of creation of the impairment record. This time record will usually coincide with the commencement time of the impairment. It is also possible, however, to advance the commencement time on the basis of available information, for example when the person calling in the complaint mentions that the impairment already started an hour ago. On the basis of the location of the area associated with the complaint, a map is shown of said area. In this example the impairment is an electrical one.

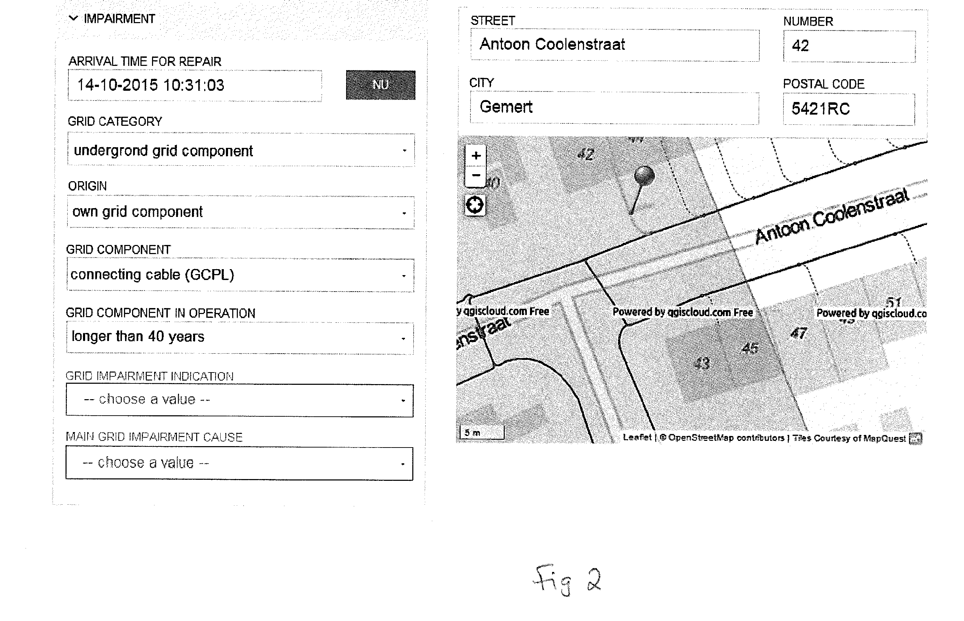

Figure 2 is an exemplary image of a screen generated as soon as the selected mechanic - sent to either resolve the impairment him or herself or to coordinate the resolution, while at the same time facilitate the settlement in case of a recoverable damage - arrives in the area of the impairment. If a probable originator of the impairment is located, for example because of the execution of excavation works in the area, exact positioning thereof is possible using GPS. On the basis of the exact positioning and the Geo Information System (GIS) related database of one or more grid operators, the one or more objects causing the impairment are being determined. A number of data relating to the electricity network are being retrieved automatically.

On the basis hereof, a probable cause can be determined in terms of one or more objects that are malfunctioning.

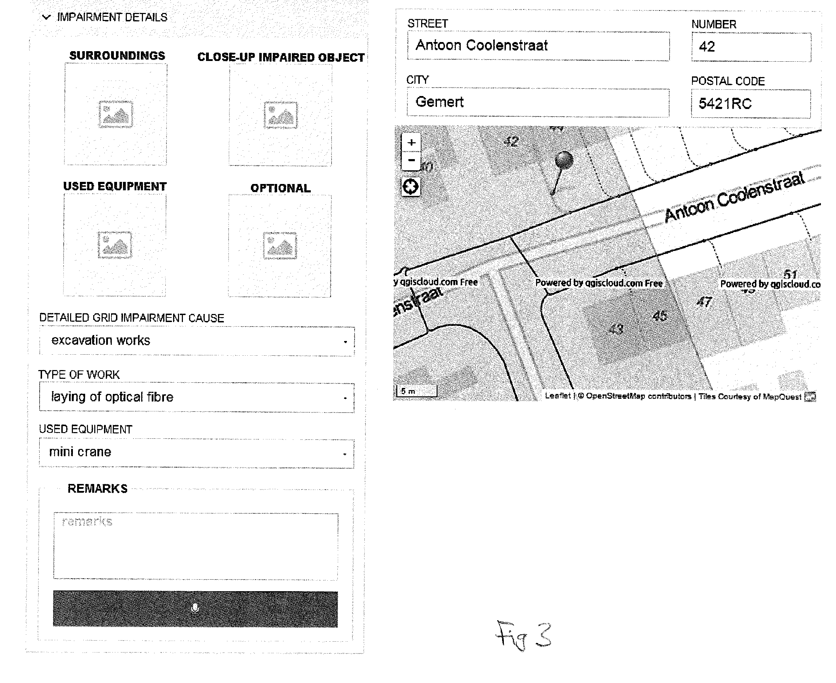

Figure 3 shows a part of the screen associated with the executed works (causing the impairments), as entered by the employee as arrived on location.

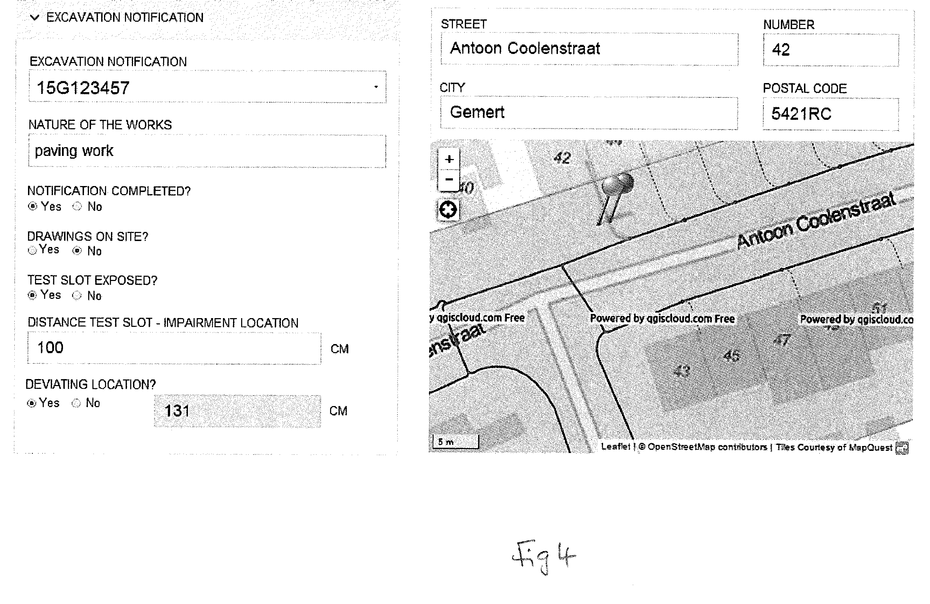

Figure 4 shows the data retrieved regarding a relevant notification with the Information Site regarding Cables and Conduits, which in this case results in the ability to establish both a probable cause of the impairment and a probable originator of the impairment.

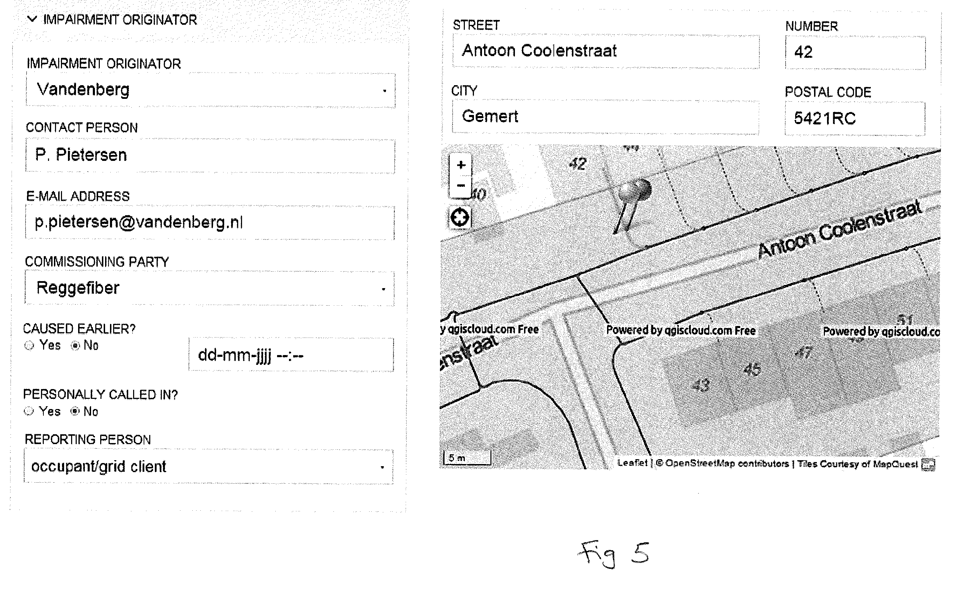

Figure 5 shows a probable originator, and the other parties related to the (excavation) works as executed by the probable originator.

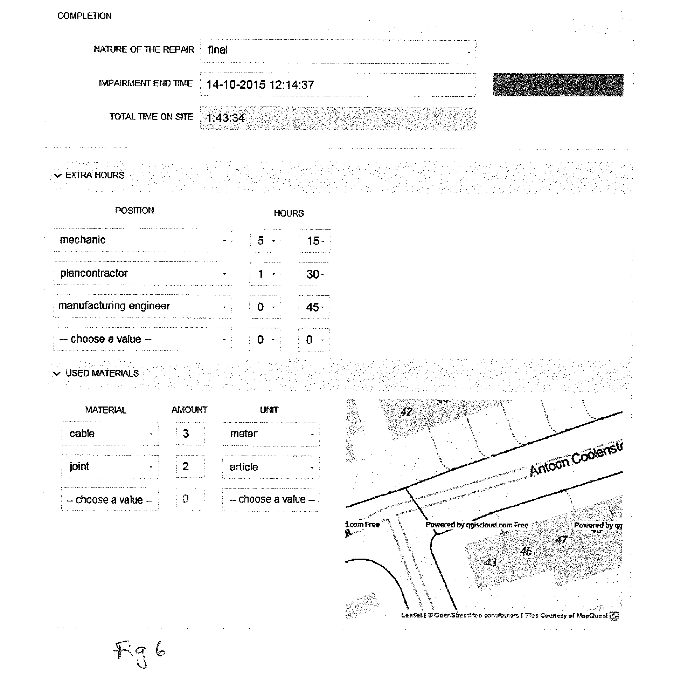

Figure 6 shows a damage report, including the costs of repair and the repair time, as assessed while using an embodiment of the program. In the map, the materials used can be visually and schematically displayed, in order to enable (in a simple manner) the proper recording of data for a revised plan (including optionally the GPS-data of the components).

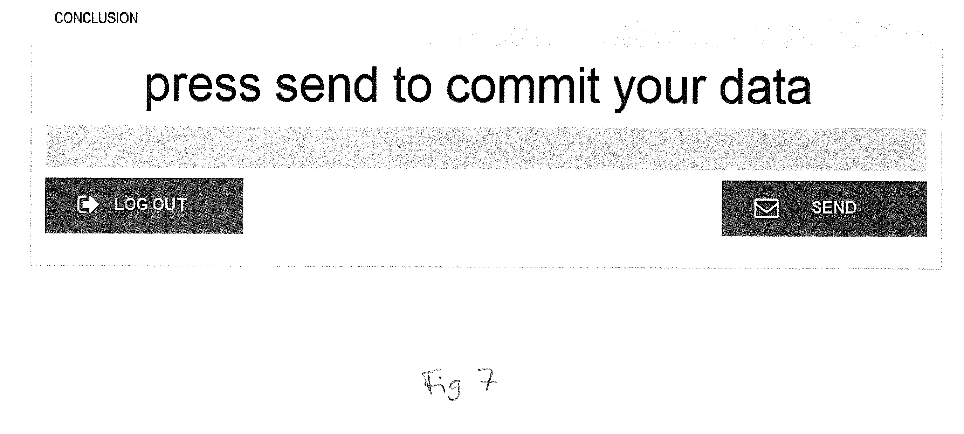

Figure 7 exemplifies a screen as shown at the point that the data as retrieved on location can be sent to those in charge of further handling of the impairment or damage case. In this example, those data may comprise of the established end time of the impairment for recording the duration of the impairment;
- the real-time reporting of the time of restoration of the impairment, so that data can be updated real-time in the NESTOR-impairment registration system or any equivalent grid impairment management system; and/or
- the recording of the end time of the impairment and/or the notification of the duration of the impairment, both based on the retrieval of the commencement time of the impairment.

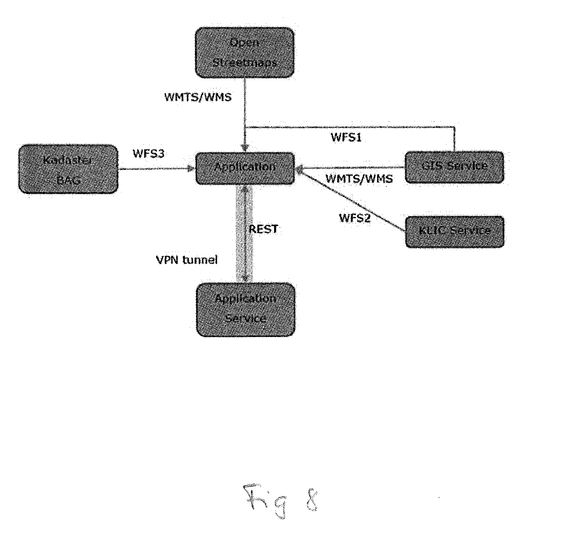

Finally, figure 8, shows schematically the interactions taking place (according to an embodiment of the program) between the program and the different sources of information.

The invention is not restricted to the above described possibilities and variants. Many adaptations and further elaborations are possible, all of which fall within the scope of the claims herein.

Where in the above, reference has been made to a GPS-system, what is meant is a satellite based positioning system, which could be GPS, but also GLONASS or any other satellite based positioning system or any positioning system based upon a multitude of satellite positioning systems.

The expression "the program is designed to perform the following step" comprises the variant that the program automatically and independently executes that step as well as the variant that the step is being executed on the basis of a human interaction, often the mechanic handling the impairment.

The invention encompasses a computer program according to the following paragraphs. The invention further comprises the carrier of a computer program, said carrier carrying the computer program according one of the following paragraphs.
1. A computer program for the handling of an impairment related to a cables and/or conduits infrastructure in an area, the impairment encompassing an observed defect and/or an at least partial malfunctioning or less functioning or a full failure in functioning of the cables and/or conduits infrastructure, the program being designed to have the computer execute the following steps:
   - determining the commencement time of the impairment, using the data from a NESTOR-impairment registration system or any equivalent grid impairment management system;
   - determining the position of the relevant area;
   - determining one or more objects causing the impairment, on the basis of the determined position and a Geo Information System (GIS) related database of one or more grid operators;
   - determining one or more causes of the impairment, on the basis of the determined position and a database that, in the relevant area and within a predetermined time frame prior to the impairment, comprises of notifications from the Information Site regarding Cables and Conduits (KLIC);
   - determining the most probable cause of the impairment, based on the multiple of cause probabilities, preferably using the location of the impairment and the commencement time thereof, and the time and location of the notifications registered with the relevant Information Site regarding Cables and Conduits.
2. Program according to paragraph 1, characterised in that the determining of the position of the relevant area is established using a GPS-system.
3. Program according to paragraph 1 or 2, characterised in that the program is also designed to perform the following step:
   - determining the most probable originator on the basis of the determination of the most probable cause.
4. Program according to paragraphs 1, 2 or 4, characterised in that the program is also designed to perform the following step:
   - determining the number of man-hours worked and/or the materials required with respect to the restoration of the impairment.
5. Program according to one of the paragraphs 1-4, characterised in that the program is also designed to perform the following step:
   - in determining the number of man-hours worked, equally determine the associated hourly fee and/or in determining the materials used, equally determine the price data for those materials, all with respect to the restoration of the impairment.
6. Program according to one of the paragraphs 1-5, characterised in that the program is also designed to perform the following step:
   - collecting image data supporting a damage claim.
7. Program according to one of the paragraphs 1-6, characterised in that the program is also designed to perform the following step:
   - registration of the end time of the impairment for the recording of the impairment duration.
8. Program according to one of the paragraphs 1-7, characterised in that the program is also designed to perform the following step:
   - real-time recording of the end time of the impairment for the purpose of real-time updating the data in the NESTOR-impairment registration system or any equivalent grid impairment management system for the infrastructure.
9. Program according to any of the paragraphs 1-8, characterised in that the program is also designed to perform the following step:
   - to determine, on a real-time basis, the duration of the impairment based on the commencement time of the impairment, and to report said duration of the impairment.
10. Program according to one of the paragraphs 1-9, characterised in that the program is also designed to perform the following step:
   - to report, on a real-time basis, the adjustment of the Geo Information System (GIS) related database of the relevant grid operator, preferably and in as far as applicable inclusive of the deviating location of the object causing the impairment, deviating relative to the location as registered in the GIS database, said deviating location optionally to be assessed on the basis of an accurate assessment of the exact location of the object being impaired, by means of GPS.
11. Program according to one of the paragraphs 1-10, characterised in that the program is also designed to perform the following step:
   - the generation of a damage report (on the basis of all available data) for the proper recording of data relating to the damage (claim).
12. Program according to one of the paragraphs 1-11, characterised in that the program is also designed to perform the following step:
   - to calculate - based on the available data, among which data about the commencement time of the impairment, the end time of the impairment, the Geo Information System (GIS) related database in which the amount of users that are connected to the damaged infrastructure, the total amount of disruption minutes and the percentage of actionable damages on the total amount of impairments and fixed variables as introduced in the system - the costs per disruption minute for the grid operator.
13. Program according to one of the preceding paragraphs, characterised in that the program is also designed to perform the following step:
   - to generate an probable causes of impairments database, comprising of a multitude of possible causes of an impairment, with a value for each probable cause, wherein each value corresponds to the number of times that a particular probable cause was indicated as the most probable cause in a predefined timeframe.
14. Program according to paragraph 13, characterised in that the probable causes of impairments database is generated by the real-time recording of data from the use of a computer and an executable computer program on such a computer for the handling of impairments in the infrastructure, while for each impairment the most probable cause is being recorded.
15. Program according one of the preceding paragraphs, characterised in that the program is also designed to perform the following step:
   - to generate a database of impairment originators comprising of an amount of possible originators of impairments, as well as a value corresponding to the number of times that, within a predefined timeframe, a possible originator has been determined as the most probable originator.
16. Program according to paragraph 15, characterised in that the impairment originators database is being generated by means of the real-time entry of data from a computer and an executable computer program on such a computer for the handling of impairments in the infrastructure, in which the most probable originator is being determined for each impairment.
17. Program according to any of the preceding paragraphs, characterised in that the program is designed to have the computer perform the following step:
   - to display the objects of the infrastructure in the relevant area, on the basis of the determined position and a Geo Information System (GIS) related database of one or more grid operators.
18. Program according to paragraph 17, characterised in that the program is designed to allocate a qualification to the objects that belong to the infrastructure, corresponding to the nature of the medium that flows through the object concerned within that infrastructure.
19. Program according to paragraph 18, characterised in that the program is designed to allocate a quantification to the objects that belong to the infrastructure corresponding to the intensity of the medium that flows through the object concerned.
20. Program according to paragraphs 13-19, characterised in that the program is designed to generate a visualisation of an infrastructure of cables and/or conduits in an area, said visualisation optionally also based on the qualifications and/or quantifications as described in paragraphs 18 and 19.
21. Program according to one of the paragraphs 13-20, characterised in that the program is also designed to indicate, per position from which the infrastructure can be invasively entered, a relative risk of damaging at least part of the infrastructure.
22. Program according to one of the preceding paragraphs, characterised in that the program is also designed to perform the following step:
   - to generate an objects database comprising of a multiple of objects together with a value for each object, wherein each value corresponds to the number of times that the relevant object in a predefined timeframe was indicated as the most probable cause.
23. Program according to paragraph 22, characterised in that the objects database is being generated by means of the real-time entry of data from a computer and an executable computer program on such a computer for the handling of impairments in the infrastructure, in which the most probable cause is being determined for each impairment.
24. Program according to paragraph 22 or 23, characterised in that the program is also designed to perform the following step:
   - to flag, based on the object database, that a critical value is surpassed, indicating that one or more objects be replaced in order to prevent that one or more of the objects will again be determined as the most probable cause of an impairment.
25. Program according to one of the preceding paragraphs, characterised in that the program is also designed to perform the following steps:
   - to authorise the user of the computer program to confirm or change of the most probable cause of the impairment as determined by the computer program;
   - to generate a notification to the user, as soon as a change or confirmation has been entered, to confirm or change the entered change or confirmation.
26. Program according to one of the preceding paragraphs, characterised in that the program is also designed to perform the following step:
   - to generate a repair time database comprising of a multiple of objects, with for each object a repair time.
27. Program according to paragraph 26, characterised in that the repair time database is being generated by means of the real-time entry of data from a computer and an executable computer program on such a computer for the handling of impairments in the infrastructure.
28. Program according to paragraph 26 or 27, characterised in that the program is designed to perform the following step:
   - to flag, during the repair work on an object, to what extent the repair time is in line with the repair time that is recorded in the repair time database for the relevant object class.
29. Program according to one of the preceding paragraphs, characterised in that the program is also designed to select a mechanic, based on the real-time database that manages the position of mechanics, for the relocation to a position in the relevant area in which impairment has been reported.
30. Program according to paragraph 29, characterised in that included in the selection process is a comparison of the time calculations, indicating for a multiple of mechanics, the amount of time the relocation will take.
31. Program according to paragraph 29 or 30, characterised in that included in the selection process is a comparison of time calculations, indicating for a multiple of mechanics, the amount of time an already commenced repair will probably take.

## Claims

1. Use of a computer and an executable computer program on such a computer for the handling of an impairment of a cables and/or conduits infrastructure in an area, the impairment encompassing an observed defect of the infrastructure and/or an at least partially insufficiently functioning or fully malfunctioning infrastructure of cables and/or conduits, the program being designed to have the computer execute the following steps:
- determining the commencement time of the impairment, using the data from a NESTOR-impairment registration system or any equivalent grid impairment management system;
- determining the position of the relevant area by means of a GPS-system;
- determining one or more objects causing the impairment, on the basis of the determined position and a Geo Information System (GIS) related database of one or more grid operators;
- determining one or more probable causes of impairment, on the basis of the determined position and a database that, in the relevant area and within a predetermined time frame prior to the impairment, comprises of notifications from the Information Site regarding Cables and Conduits (KLIC);
- determining the most probable cause of the impairment, based on the one or more probable causes of impairment, on the basis of the location of the impairment and the commencement time thereof, and preferably on the basis of the time and location of the notifications registered with the relevant Information Site regarding Cables and Conduits;
while the program is also designed to perform the following step:
- registration of the end time of the impairment for the recording of the impairment duration; and/or
- the real-time recording of the end time of the impairment for the purpose of real-time updating the data in the NESTOR-impairment registration system or any equivalent grid impairment management system for the infrastructure; and/or
- to determine, on a real-time basis, the duration of the impairment based on the commencement time of the impairment, and to report said duration of the impairment.

2. Use according to claim 1, **characterised in that** the program is also designed to perform the following step:
- determining the most probable originator on the basis of the determination of the most probable cause.

3. Use according to claim 1 or 2, **characterised in that** the program is also designed to perform the following steps:
- determining the number of man-hours worked and/or the materials required with respect to the restoration of the impairment; and
- in determining the number of man-hours worked, equally determine the associated hourly fee and/or in determining the materials required, equally determine the price data for those materials, all with respect to the restoration of the impairment.

4. Use according to one of the claims 1-3, **characterised in that** the program is also designed to perform the following step:
- to generate one or more image data for supporting a damage claim settlement.

5. Use according to one of the claims 1-4, **characterised in that** the program is also designed to perform the following step:
- to report, on a real-time basis, any adjustment in the Geo Information System (GIS) related database of the relevant grid operator.

6. Use according to one of the claims 1-5, **characterised in that** the program is also designed to perform the following step:
- the generation, on the basis of the available data, of a damage report for the proper recording of data relating to the damage claim.

7. Use according to one of the claims 1-6, **characterised in that** the program is also designed to perform the following step:
- to calculate - based on the available data, among which data about the commencement time of the impairment, the end time of the impairment, the Geo Information System (GIS) related database in which the amount of users that are connected to the damaged infrastructure, the total amount of disruption minutes and the percentage of actionable damages on the total amount of impairments and fixed variables as introduced in the system - the costs per disruption minute for the grid operator.

8. Use according to one of the preceding claims, **characterised in that** the program is also designed to perform the following step:
- to generate an objects database comprising of a multiple of objects together with a value for each object, wherein each value corresponds to the number of times that the relevant object in a predefined timeframe was indicated as the most probable cause.

9. Use according to one of the preceding claims, **characterised in that** the program is also designed to perform the following step:
- to generate a repair time database comprising of a multiple of objects, with for each object a repair time.

10. Use according to claim 9, **characterised in that** the program is also designed to perform the following step:
- to flag, during the repair work on an object, to what extent the repair time is in line with the repair time that is recorded in the repair time database for the relevant object.

11. Use according to one of the claims 8-10, **characterised in that** the program is also designed to perform the following step:
- to flag, based on the object database, that a critical value is surpassed, indicating that one or more objects be replaced in order to prevent that one or more of the objects will again be determined as the most probable cause of an impairment.

12. Use according to one of the preceding claims, **characterised in that** the program is also designed to perform the following step:
- the real-time reporting of any adjustment made or to be made to the Geo Information System (GIS) related database of the relevant grid operator with respect to an observed deviating location of an object that caused the impairment, relative to the location registered in the GIS database.

13. Use according to claim 12, **characterised in that** the program is also designed to perform the following step:
- determining the deviating location by means of a real-time assessment of the exact location of the impaired object by means of a GPS-system.

14. Use according to one of the preceding claims, **characterised in that** the program is also designed to perform the following step:
- to calculate - on the basis of the available data, amongst which the commencement time of the impairment, the end time of the impairment, the total amount of disruption minutes and the percentage of damages relative to the amount of impairments - the costs for a grid operator for maintaining the facilities to resolve impairments.
